(19) Europäisches Patentamt
European Patent Office
Office européen des brevets

(11) **EP 1 860 701 A2**

(12) **EUROPEAN PATENT APPLICATION**

(43) Date of publication:
**28.11.2007 Bulletin 2007/48**

(51) Int Cl.:
***H01L 27/146*** *(2006.01)*

(21) Application number: **07010153.0**

(22) Date of filing: **22.05.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **23.05.2006 JP 2006143173**

(71) Applicant: **MATSUSHITA ELECTRIC INDUSTRIAL CO., LTD.**
**Osaka 571-8501 (JP)**

(72) Inventor: **Uchida, Mikiya**
**c/o Matsushita Electric Industrial Co., Ltd.**
**Osaka-shi, Osaka 540-6319 (JP)**

(74) Representative: **Menges, Christian Alexander et al**
**Diehl & Partner GbR.**
**Augustenstr. 46**
**80333 Munich (DE)**

(54) **Solid-state imaging device and method of manufacturing the same**

(57)    A solid-state imaging device that realizes a reduction in 1/f noise in an amplifying transistor in a pixel cell and an analog circuit as a peripheral circuit, and a method of manufacturing the same are provided. A solid-state imaging device according to the present invention includes: a plurality of pixel cells that are arranged in a matrix form on a semiconductor substrate 100; and peripheral circuits that allow a signal to be outputted from the pixel cells via a predetermined signal line. Gate insulating films of a plurality of transistors constituting the solid-state imaging device include both a nitrided gate insulating film 105 and a non-nitrided gate insulating film 103.

FIG. 1

EP 1 860 701 A2

**Description**

The present invention relates to a solid-state imaging device, and more particularly relates to a MOS type solid-state imaging device and a method of manufacturing the same.

In recent years, with the advancement of element size miniaturization in semiconductor devices in general use, progress has been made in advancing the same also in solid-state imaging devices using MOS type transistors. This makes it possible to miniaturize a pixel cell pitch in a MOS type solid-state imaging device, and thus even with the same optical size, i.e. even with a light receiving region in which a pixel array is present having a constant area, by disposing an increased number of pixel cells in the light receiving region, a high resolution solid-state imaging device can be configured.

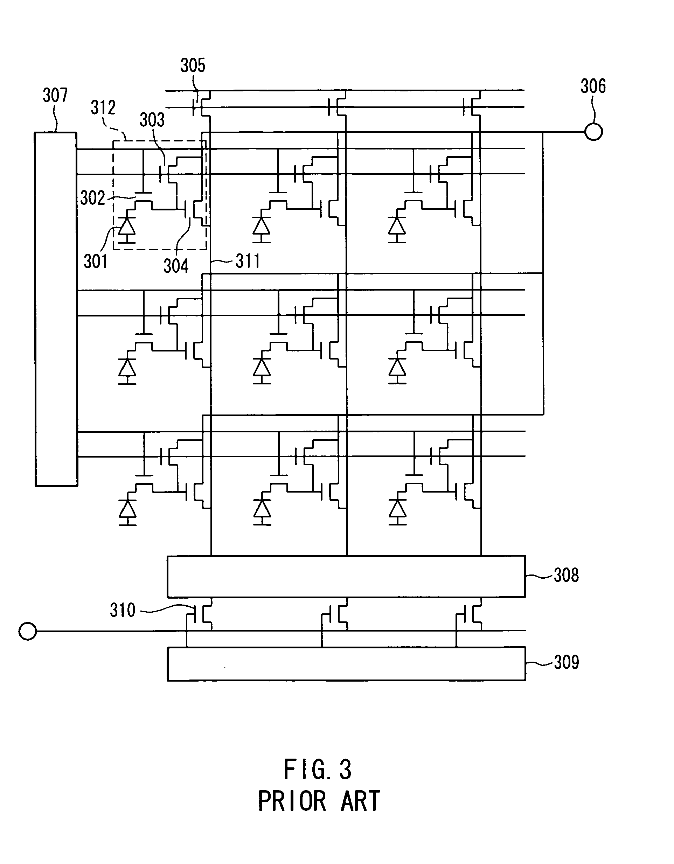

FIG. 3 is a circuit diagram showing a typical configuration of a MOS type solid-state imaging device.

A solid-state imaging device shown in FIG. 3 includes a photodiode 301, a transfer transistor 302, an amplifying transistor 304, and a reset transistor 303, and further includes a plurality of pixel cells 312 that are arranged in a matrix form, a plurality of vertical signal lines 311, a plurality of common drain lines 306, a vertical driver circuit 307, a noise suppressing circuit 308, and a horizontal driver circuit 309. Drains of the amplifying transistor 304 and the reset transistor 303 are connected to one of the common drain lines 306. Further, a source of the amplifying transistor 304 is connected to one of the vertical signal lines 311. Each of the vertical signal lines 311 is connected at one end to a load transistor 305 and at the other end to the noise suppressing circuit 308. An output of the noise suppressing circuit 308 is connected to a horizontal selection transistor 310 that is driven by the horizontal driver circuit 309.

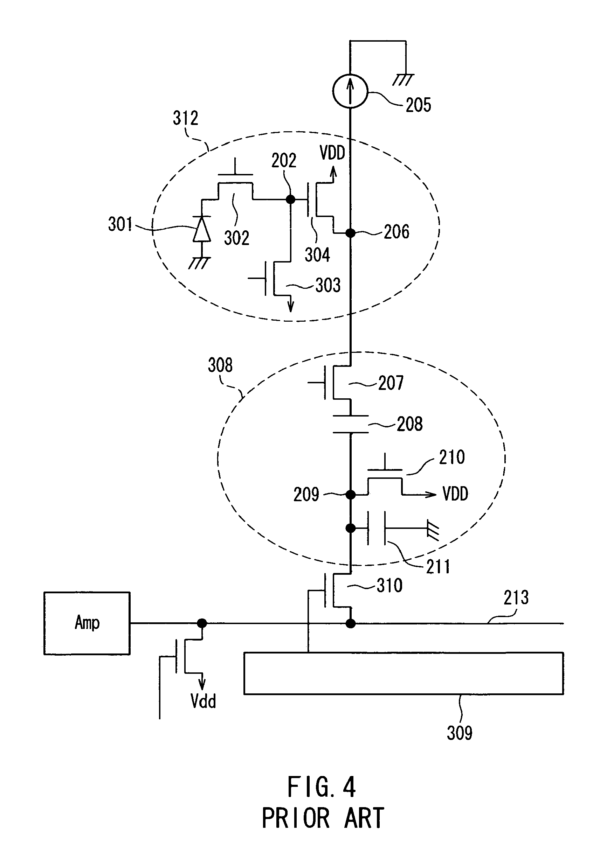

The description is now directed to the operations of each of the pixel cells 312 and the noise suppressing circuit 308 with reference to FIG. 4. In FIG. 4, a portion of a MOS type solid-state imaging device is shown, which includes a pixel cell, a noise suppressing circuit, and a horizontal shift register (SR), with other portions omitted. First, by turning on and off the reset transistor 303, the potential of a floating diffusion 202 is reset to a value of VDD. At this time, based on an operating point of the amplifying transistor 304 defined by a constant current source 205, a potential V1 of a vertical signal line (for example, a potential at a node 206) satisfies an expression (a) below.

$$V1 = VG - VGS = VDD - VGS \quad \dots (a)$$

Herein, VG indicates a gate potential of the amplifying transistor 304, and VGS indicates a gate-source voltage of the amplifying transistor 304. Further, a value of VGS is determined as a constant based on an operating point of the amplifying transistor 304.

Next, in a state in which, by turning on a transistor 210 in the noise suppressing circuit 308, a potential at a node 209 is controlled so as to have a value of VDD, a transistor 207 is turned on so that a capacitor 208 is charged. At this time, defining a capacitance of the capacitor as C1, an electric charge Q charged in the capacitor 208 satisfies an expression (b) below.

$$C1 (VDD - V1) = Q \quad \dots (b)$$

Next, by turning off the transistor 210 and subsequently turning on the transfer transistor 302, an electric charge Q1 stored in the photodiode 301 is transferred to the floating diffusion 202. Defining a capacitance of the floating diffusion 202 as C, a potential of the floating diffusion 202 changes to a value expressed by (VDD - Q1 /C).

At this time, a potential V2 at the node 206 satisfies an expression (c) below.

$$V2 = VDD - Q1 / C - VGS \quad \dots (c)$$

The electric charge Q that has been charged initially in the capacitor 208 is distributed to each of the capacitors 208 and 211 in accordance with respective capacitance values of the capacitors 208 and 211. Herein, defining a potential at the node 209 as Vout, and an amount of a variation in the electric charge that has been charged in the capacitor 208 as $\Delta Q$, expressions (d) and (e) below hold.

$$C1 \, (Vout - V2) = Q + \Delta Q \quad ... \,(d)$$

$$C2 \, Vout = -\Delta Q \quad\quad\quad ... \,(e)$$

By solving the above-mentioned expressions (a) to (e), a value of Vout is determined according to an expression (f) below.

$$Vout = C1 \, / \, (C1 + C2) \times (VDD - Q1 \, / \, C) \quad ... \,(f)$$

By turning on the horizontal selection transistor 310, the potential Vout expressed by the above-mentioned expression (f) is outputted to an amplifier via a horizontal signal line 213.

By the way, in a semiconductor integrated circuit device such as a microcomputer or a logic element, when element size miniaturization is performed, 1) a size reduction of an element is performed so as to conform to the scaling law as much as possible; 2) a thickness reduction of a gate insulating film of a MOS transistor is performed; or 3) a power supply voltage is lowered. In contrast to this, in a solid-state imaging device as shown in FIGs. 3 and 4, element size miniaturization is performed differently from these measures.

First of all, as for a solid-state imaging device, it is of importance to place high priority on ensuring that a region in which a photodiode is disposed has a predetermined area in a pixel cell, thereby to maintain characteristics of the photodiode such as sensitivity and a saturation number of electrons. Therefore, when element size miniaturization is performed in a solid-state imaging device, unlike the case of a CMOS logic LSI or the like where the size of every element is simply reduced proportionally so as to conform to the scaling law, a design is adopted in which size miniaturization is performed with respect to a transistor included in a pixel cell or in a peripheral circuit while preventing a decrease in photodiode area as much as possible.

Furthermore, in a solid-state imaging device, if, in a pixel cell, the thickness of a gate insulating film simply is reduced and a power supply voltage is lowered accordingly, a dynamic range of a signal voltage outputted from the pixel cell is decreased, so that an amplitude of light received by a photodiode cannot be outputted as an amplitude of a large voltage, resulting in a S/N ratio being impaired. Therefore, with respect to a pixel cell, a design is adopted in which lowering of a power supply voltage and a thickness reduction of a gate insulating film are rather suppressed. With this also imposing a limitation on element size miniaturization, the above-described simple measure of proportionally reducing a size employed in the case of a CMOS logic LSI or the like is not suitable in this case. Hence, in performing element size miniaturization in a solid-state imaging device, in many cases, the conventional technique of simply reducing the thickness of a gate insulating film and lowering a power supply voltage accordingly only can be applied to an element constituting a peripheral circuit.

In summary, miniaturization of elements in a solid-state imaging element allows the number of pixel cells to be increased and thus is useful in obtaining improved resolution of an image. However, in this case, the miniaturization is implemented not in a simple manner as in the case of a CMOS logic but in such manners that: (1) in a pixel cell, higher priority is placed on securing or maintaining a photodiode area than on achieving miniaturization of elements; that (2) in a pixel cell, simple scaling of the thickness of a gate insulating film and a power supply voltage is suppressed; and that (3) scaling of a peripheral circuit is implemented in the same manner as in the case of a CMOS logic.

By the way, when performing size miniaturization of MOS transistors in general use, disadvantageously, variations may occur in respective characteristics of the transistors under the influence of, for example, short channel characteristics, which will be described later. Since such variations in the respective characteristics of the transistors may lead to nonuniformity attributable to a difference in characteristics between elements, process refinement is performed that is necessary to suppress variations in transistor characteristics.

For example, in a manufacturing process of a CMOS logic semiconductor device of a generation in which the minimum gate length is less than $0.3 \, \mu m$, generally, a dual-gate structure is adopted in which a n-type polysilicon gate electrode is used in a n-channel MOS transistor, and a p-type polysilicon gate electrode is used in a p-channel MOS transistor. The reason why the dual-gate structure is adopted as described above is that, using a surface channel structure, potential control with respect to a semiconductor substrate surface region in a channel portion (immediately below a gate electrode, near an interface between a Si substrate and a gate insulating film) is performed based on a gate electric field as much as possible, and thus current control between a source and a drain can be facilitated.

Furthermore, as another measure to perform potential control with respect to a channel by basing it on a gate electric field as much as possible, a thickness reduction of a gate insulating film also is performed. However, in the above-described dual-gate structure, a boron impurity that is used generally to turn the conductivity type of a polysilicon gate to a p-type has a property of seeping from a gate electrode into a gate insulating film by a heat treatment performed after the formation of the gate electrode. When boron seeps from a gate electrode into a gate insulating film, characteristics of a semiconductor device vary from those designed. This phenomenon becomes more significant in the case of using a gate insulating film having a reduced thickness.

Furthermore, in the case where, as a result of a thickness reduction of a gate insulating film, the thickness of the gate insulating film is reduced to less than 5 nm, a tunnel current flows from a gate electrode to a semiconductor substrate via a gate insulating film, i.e. gate leakage occurs. This can be a serious problem with a circuit configuration utilizing a high input impedance of a gate of a MOSFET. This problem can be particularly severe in the case of a solid-state imaging element since a signal electric charge often is handled as a MOSFET gate input therein.

As a measure to avoid this seepage of boron and gate leakage, nitriding of a gate insulating film is performed in a semiconductor manufacturing process. The reasons for this are that a nitrided oxide film has an effect of suppressing boron diffusion, and that since a relative dielectric constant becomes high, an effective insulating film thickness can be increased.

However, this technique of nitriding a gate insulating film has been found to present another problem in that an interface level at an interface between a gate insulating film and a semiconductor substrate increases to cause 1/f noise. That is, when a gate insulating film is nitrided, a level is generated in an energy band gap of the gate insulating film due to nitrogen, so that 1/f noise is generated due to an exchange of an electric charge between the level and a channel of a transistor. Herein, in a solid-state imaging device, an electric signal generated by photoelectric conversion is amplified by a transistor to be outputted, and therefore, an increase in 1/f noise due to nitriding of a gate insulating film may cause a S/N ratio of an electric signal in the solid-state imaging device to be deteriorated.

Moreover, in a solid-state imaging device, as described above, even in the case where a pixel cell area is reduced, a measure is adopted in which size miniaturization is performed only with respect to a transistor included in a pixel cell while maintaining a photodiode area constant as much as possible, and therefore, in many cases, an amplifying transistor included in a pixel cell is sized so as to have approximately a minimum gate length and approximately a minimum gate width.

Herein, generally, noise voltage density $Vn^2$ of 1/f noise is expressed by

$$Vn^2 = K / (Cox \cdot W \cdot L \cdot f)$$

Vn:     noise voltage density [V /√ Hz]
K:       constant
Cox:    gate insulating film capacitance [F /$\mu$m2]
W:       gate width [$\mu$m]
L:        gate length [$\mu$m]
f:        frequency [Hz].

This explains that an amplifying transistor in a pixel cell of a solid-state imaging device, which has a gate width W and a gate length L that are decreased respectively to approximately a minimum gate length and approximately a minimum gate width is one of the transistors most vulnerable to the influence of 1/f noise.

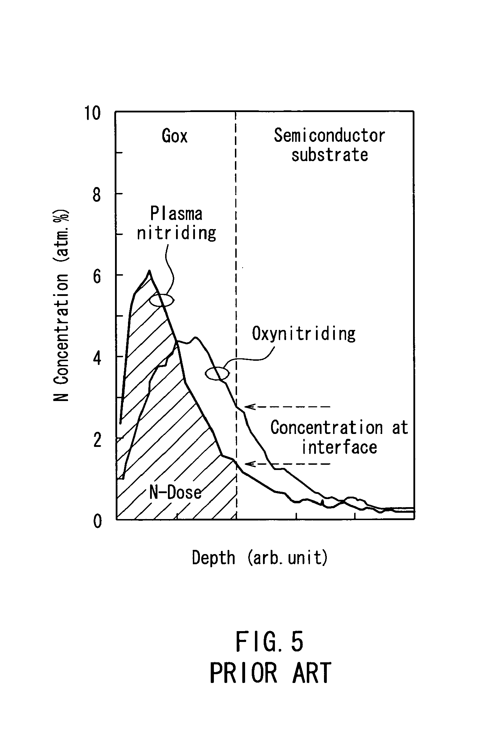

As described in, for example, JP 2004-311739 A and JP 2004-296603 A, recent years have seen the use of plasma nitriding replacing the conventional oxynitriding as a method of nitriding a gate insulating film, which improves film thickness control and allows a desired nitrogen concentration to be obtained. Also, as shown by nitrogen concentration curves obtained by a SIMS analysis in FIG. 5, an attempt has been made to set a concentration of nitrogen contained in a gate insulating film so that its peak is away from an interface between the gate insulating film and a semiconductor substrate, thereby decreasing a nitrogen concentration at the interface. This technique has been applied also to solid-state imaging devices, and as described in the document "Chang-Rok Moon *et al..:* International Electron Device Meeting 2005 Technical Digest, 33.2 (2005)", the effect of reducing 1/f noise has been reported.

However, as can be clearly seen from the nitrogen concentration curves shown in FIG. 5, even in the case of using plasma nitriding, a peak concentration of nitrogen at the interface between the gate insulating film and the semiconductor substrate is about one-half that in the case of using oxynitriding, which means that nitrogen still exists in a given amount or more. Because of this, the degree of 1/f noise is worse than that in the case of using a pure oxide film as a gate insulating film.

Meanwhile, the above-described amplifying transistor included in a pixel cell of a solid-state imaging device is configured generally of a n-channel transistor, and in the pixel cell, since scaling of the thickness of a gate insulating film and a power supply voltage should be suppressed in order not to deteriorate a S/N ratio of an outputted signal as described above, the gate insulating film is used as it is without a reduction in thickness. Therefore, when it only comes to a n-channel amplifying transistor in a pixel cell, there are primarily no problems of seepage of boron through a gate electrode and a gate insulating film and of gate leakage.

Furthermore, this also applies to a transistor of an analog circuit used for signal processing as a peripheral circuit of a solid-state imaging device, as long as the transistor is a n-channel transistor, and a thickness of not less than 5 nm of a gate insulating film can be secured. Therefore, in the case where an amplifying transistor in a pixel cell and an analog circuit as a peripheral circuit as described above are configured of a n-channel MOS transistor with a gate insulating film having a relatively large thickness, there is essentially no need for nitriding of a gate insulating film. On the other hand, in a portion in which a logic circuit and a driving circuit are formed as peripheral circuits, and a miniaturized transistor and a gate insulating film of a reduced thickness are required for a high-speed operation, nitriding of the gate insulating film is necessary to solve these problems.

As described above, in a solid-state imaging device, depending on a configuration of each transistor element, nitriding of a gate insulating film is not necessarily required to be performed with respect to every transistor; rather, there are even cases in which nitriding of a gate insulating film leads to deterioration of output characteristics. However, in the conventionally performed method of oxynitriding a gate insulating film, a gate insulating film is heated to a temperature of about 1100°C in an atmosphere of NO + $O_2$ gas or the like, and thus there can be no other way than to nitride gate insulating films on an entire surface of a wafer. Further, even in the method of nitriding a gate insulating film by plasma nitriding, since there had been no means for forming a nitrided gate insulating film and a non-nitrided gate insulating film separately from each other on a common semiconductor substrate or on a chip, it has been the case that nitriding is performed even with respect to a gate insulating film that essentially is not required to be nitrided and rather is not desired to be nitrided because of the problem of 1/f noise.

In order to solve the above-described problems, it is an object of the present invention to realize a solid-state imaging device that allows a nitrided gate insulating film and a non-nitrided gate insulating film to coexist therein, and a method of manufacturing the same.

A solid-state imaging device according to the present invention includes: a plurality of pixel cells that are arranged in a matrix form on a semiconductor substrate; and peripheral circuits that allow a signal to be outputted from the pixel cells via a predetermined signal line. In the solid-state imaging device, gate insulating films of a plurality of transistors constituting the solid-state imaging device include both a nitrided gate insulating film and a non-nitrided gate insulating film. This configuration can prevent the contamination of nitrogen as an impurity into a gate insulating film that essentially is not required to be nitrided so as to suppress an increase in 1/f noise due to an increase in interface level, thereby preventing deterioration of a S/N ratio of a solid state imaging device.

Furthermore, a method of manufacturing a solid-state imaging device according to the present invention is a method of manufacturing a solid-state imaging device including: a plurality of pixel cells that are arranged in a matrix form on a semiconductor substrate; and peripheral circuits that allow a signal to be outputted from the pixel cells via a predetermined signal line. The method includes the process steps of forming, on the semiconductor substrate, a gate insulating film of transistors constituting the solid-state imaging device; masking a portion on the gate insulating film with a mask layer; performing plasma nitriding with respect to a region of the gate insulating film that is not masked with the mask layer; peeling off the mask layer; annealing the semiconductor substrate; and forming a gate electrode on the semiconductor substrate. This method facilitates selective nitriding in which nitriding is not performed with respect to a gate insulating film that essentially is not required to be nitrided.

According to the solid-state imaging device and the method of manufacturing the same of the present invention, a gate insulating film that is desired to be nitrided and a gate insulating film that is not desired to be nitrided can coexist, and thus a gate insulating film of a transistor constituting each of a logic circuit and a driving circuit as peripheral circuits and a gate insulating film of a transistor constituting each of an amplifying transistor in a pixel cell and an analog circuit as a peripheral circuit can be formed separately from each other so that the former is nitride while the latter is not nitrided. Therefore, in addition to providing an effect of suppressing boron seepage and gate leakage, this further allows a non-nitrided oxide film to be used as a gate insulating film in each of an amplifying transistor in a pixel cell and an analog circuit as a peripheral circuit, and thus can realize a reduction in 1/f noise by completely removing the influence of an interface level attributable to nitrogen, while maintaining desired transistor characteristics as designed of a solid-state imaging device.

In the above-described solid-state imaging device according to the present invention, it is preferable that among the transistors, a transistor having the non-nitrided gate insulating film is an amplifying transistor in each of the pixel cells. This is because an amplifying transistor in a pixel cell is one of the transistors most vulnerable to the influence of 1/f noise.

Furthermore, it is more preferable that among the transistors, a plurality of transistors constituting the peripheral circuits include both a n-channel transistor and a p-channel transistor, while at least part of transistors constituting the pixel cells is a n-channel transistor, and at least part of the n-channel transistors has the non-nitrided gate insulating film. This is because, in a n-channel transistor, a n-type polysilicon gate electrode is used, and thus boron seepage from the gate electrode does not occur, thereby eliminating the problem of a variation in transistor characteristics without the need to perform nitriding of a gate insulating film.

Moreover, it is preferable that the n-channel transistor includes a gate electrode doped with a n-type impurity, and the p-channel transistor includes a gate electrode doped with a p-type impurity. Alternatively, it is preferable that both of the n-channel transistor and the p-channel transistor include a gate electrode doped with a n-type impurity.

Furthermore, in the above-described method of manufacturing a solid-state imaging device according to the present invention, it is preferable that a region in each of the pixel cells in which an amplifying transistor is formed is masked with the mask layer. Based on the fact that an amplifying transistor in a pixel cell is one of the transistors most vulnerable to the influence of 1/f noise, this is intended to prevent a gate insulating film of the amplifying transistor from being nitrided.

Moreover, it is more preferable that among the transistors, a plurality of transistors constituting the peripheral circuits include both a n-channel transistor and a p-channel transistor, while at least part of transistors constituting the pixel cells is a n-channel transistor, and a region in which at least part of the n-channel transistors is formed is masked with the mask layer. Based on the fact that in a n-channel transistor, a n-type polysilicon gate electrode is used and thus boron seepage from the gate electrode does not occur, this is intended to prevent a gate insulating film of the n-channel transistor from being nitrided.

FIG. 1 is a schematic diagram showing two types of transistors having a nitrided gate insulating film and a non-nitrided gate insulating film, respectively.

FIG. 2 is a diagram explaining a method of manufacturing two types of transistors having a nitrided gate insulating film and a non-nitrided gate insulating film, respectively.

FIG. 3 is a circuit diagram showing a typical configuration of a MOS type solid-state imaging device.

FIG. 4 is a diagram showing a main portion of a circuit configuration for explaining part of operations of a pixel cell and a noise suppressing circuit in a MOS type solid-state imaging device.

FIG. 5 is a diagram showing nitrogen distributions in a gate insulating film.

Hereinafter, the solid-state imaging device according to the present invention will be described in detail with reference to the appended drawings.

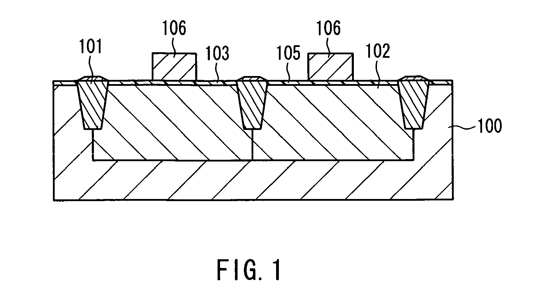

FIG. 1 is a schematic diagram showing a case where a MOS transistor having a nitrided gate insulating film and a MOS transistor having a non-nitrided gate insulating film are formed on a common semiconductor substrate 100.

With respect to two transistors separated to the left and right by an element isolator 101, a nitrided gate insulating film 105 and a non-nitrided gate insulating film 103 are formed on a p-type well 102, respectively, and a gate electrode 106 is disposed on each of the gate insulating films 105 and 103. It is to be noted that this diagram shows a state in which in a solid-state imaging device, a MOS transistor having a gate insulating film formed substantially of an oxide film and a MOS transistor having a gate insulating film formed of a nitride oxide film are placed side-by-side, and is not a cross-sectional view of a particular portion of the solid-state imaging device.

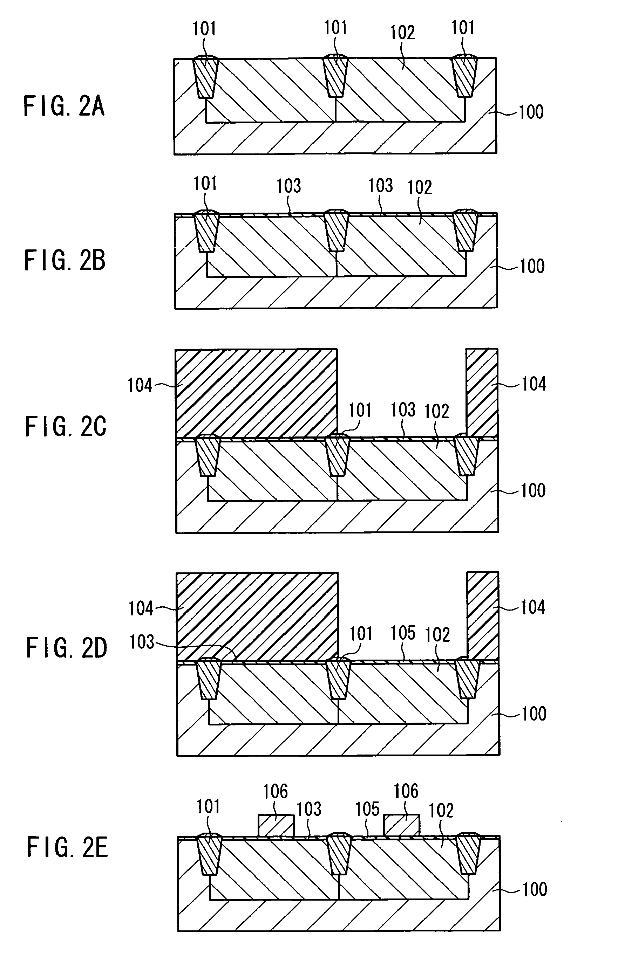

By referring to FIG. 2, the following describes a manufacturing method for forming two MOS transistors having different types of gate insulating films on a common semiconductor substrate.

First, on the semiconductor substrate 100 in which the element isolators 101 and the p-type well 102 are formed as shown in FIG. 2(A), the gate insulating film 103 is formed by thermal oxidation as shown in FIG. 2(B). This gate insulating film 103 is a pure silicon oxide film that does not contain nitrogen as an impurity and could be formed by a conventionally known normal method. Specific forming conditions are, for example, as follows.

| | |
|---|---|
| Gas: | diluted oxygen (mixture of $O_2$ and $N_2$, $O_2$: 5%) |
| Temperature: | 800°C to 900°C |
| Treating time: | 10 to 20 minutes |

Herein, as shown in FIG. 2(C), in order to obtain a mask layer for masking a n-channel transistor region as one of transistor regions, a resist is applied to form a resist film that then is subjected to conventional treatments of exposure and development, and thus a patterned resist 104 is obtained.

Plasma nitriding is performed in this state under, for example, the following conditions.

High-frequency power: 13.56 MHz, 500W

| | |
|---|---|
| Gas: | $N_2$ |
| Pressure: | 5 Pa |
| Treating time: | 10 to 120 seconds |
| Stage temperature: | 20°C |

At this time, a surface of the gate insulating film in a portion exposed to nitrogen plasma is nitrided while the surface in a portion covered with the resist is not nitrided, and thus the nitrided gate insulating film 105 and the non-nitrided gate insulating film 103 can be formed separately from each other as shown in FIG. 2(D).

Next, after removing the resist using a chemical solution such as a mixture solution of sulfuric acid and hydrogen peroxide, post-annealing is performed under, for example, the following conditions.

| | |
|---|---|
| Temperature: | 800 to 1100°C |
| Gas: | oxygen or nitrogen atmosphere |
| Time: | 10 to 120 seconds |

This process stabilizes film quality. After that, a gate electrode material film such as of silicon is deposited, and patterning is performed so that the gate electrodes 106 are formed as shown in FIG. 2(E), and thus a basic transistor configuration is obtained.

In the method of manufacturing a solid-state imaging device, process steps to be followed after the formation of a gate electrode are the same as those well known, and thus duplicate descriptions thereof are omitted herein.

The description is directed next to a configuration of the solid-state imaging device according to the present invention.

According to the above-described method, a gate insulating film that is formed substantially of an oxide film and a gate insulating film that is formed of a nitride oxide film can be formed on one semiconductor substrate, allowing this to be applied to solid-state imaging devices in practical use. A solid-state imaging device according to this embodiment has both a gate insulating film that is formed substantially of an oxide film and a gate insulating film that is formed of a nitride oxide film on a semiconductor substrate thereof.

The solid-state imaging device according to this embodiment has the same basic circuit configuration as the typical circuit configuration of the solid-state imaging device shown in FIG. 3. Herein, a pixel cell includes, as well as the photodiode 301, three transistors that are the transfer transistor 302, the amplifying transistor 304, and the reset transistor 303. In the solid-state imaging device according to this embodiment, as a gate insulating film of the amplifying transistor 304 among these transistors, a non-nitrided gate insulating film is used, and the amplifying transistor 304 is formed of a n-channel transistor. This is because the amplifying transistor 304 is the only transistor that may cause 1/f noise when image capturing is performed, and with the use of a n-channel transistor as the amplifying transistor 304, boron seepage is no longer a matter of concern.

The following explains, in a little more detail, why the amplifying transistor 304 is the only transistor that may cause 1/f noise, while the other transistors are not particularly regarded as problematic.

First, regarding the transfer transistor 302, insofar as electric charges can be transferred completely from the photodiode 301, no electric charges remain in a channel, and thus an exchange of an electric charge between the channel and an interface level at an interface between a gate insulating film and a semiconductor substrate, which may cause 1/f noise, does not occur.

Furthermore, regarding the reset transistor 303, although it may cause offset noise (referred to as kTC noise) when resetting is performed, as can be understood also from the operation of the noise suppressing circuit described with reference to FIG. 4, an output potential V1 from a pixel cell in an initial reset state and an output potential V2 from the pixel cell in a state where electric charges are transferred are expressed respectively by:

$$V1 = VDD - VGS \qquad \dots (a)$$

$$V2 = VDD - VGS - Q\,/\,C \qquad \dots (c),$$

and a final output is expressed by:

$$Vout = C1\,/\,(C1 + C2) \times (VDD - V1 + V2)$$
$$= C1\,/\,(C1 + C2) \times (VDD - Q1\,/\,C) \qquad \dots (f).$$

Herein, even in the case where offset noise (kTC noise) "offset" is added to a reset potential of the pixel cell as expressed by:

$$V1 = VDD + offset - VGS$$

$$V2 = VDD + offset - VGS - Q / C,$$

in the final output, the offset noise is cancelled out by the operation "V2 - V1" in the the equation, thereby presenting no substantial problem.

The description is directed next to transistors constituting peripheral circuits.

Among the vertical driver circuit 307, the noise suppressing circuit 308, and the horizontal driver circuit 309 that constitute peripheral circuits, first, regarding the noise suppressing circuit 308, a non-nitrided gate insulating film is used in a MOS transistor constituting the noise suppressing circuit 308. This is because, in the noise suppressing circuit, since an image signal generated in the photodiode 301 is handled as described above, there is a need to avoid the influence of 1/f noise.

Meanwhile, among the peripheral circuits, regarding the vertical driver circuit 307 and the horizontal driver circuit 309, a nitrided gate insulating film is used for each of them. This is because transistors constituting these circuits are required to be driven at a high speed and thus are desired to be configured of a miniaturized transistor. Therefore, it is desirable that a gate insulating film containing a nitrogen impurity be used, which allows a gate insulating film of a MOS transistor to have an increased effective film thickness.

Furthermore, the solid-state imaging device according to the present invention can employ the dual-gate structure, and in that case, the following configuration of the transistors could be adopted.

For example, in the case of a solid-state imaging device with two voltage systems composed of low-voltage MOS transistors (for example, having a power supply voltage of 1.5 V and a gate insulating film thickness of 3 nm) such as the vertical driver circuit 307, the horizontal driver circuit 309, a shift register, and other components including a digital signal processing circuit; and high-voltage MOS transistors (for example, having a power supply voltage of 3.3 V and a gate insulating film thickness of 7 nm) that handle a signal from a photodiode, such as the pixel cell 312, the noise suppressing circuit 308, an amplifier, and an analog signal processing circuit, a nitrided gate insulating film is used in each of a n-channel low-voltage MOS transistor and a p-channel low-voltage MOS transistor. Further, in this case, a non-nitrided gate insulating film is used in each of a n-channel high-voltage MOS transistor and a p-channel high-voltage transistor. This is based on the following. That is, with respect to the n-channel low-voltage MOS transistor, there is a need to prevent gate leakage, and with respect to the p-channel low-voltage MOS transistor, this is intended to prevent boron seepage as well as gate leakage. On the other hand, with respect to the high-voltage MOS transistor, since it handles an image signal, it is desirable that a non-nitrided gate insulating film be used so that 1/f noise is avoided. Similarly the high-voltage p-channel MOS transistor also handles an image signal, and thus in the case of the high-voltage p-channel transistor, the problems of gate leakage and boron seepage are avoided by the use of a gate insulating film having a thickness of not less than 5 nm rather than by nitriding of a gate insulating film.

As far as the circuit elements shown in FIG. 3 are concerned, the noise suppressing circuit 308 is configured generally of an analog circuit and thus, in many cases, is formed of a high-voltage MOS transistor so that a dynamic range of a signal is secured. On the other hand, the vertical driver circuit 307 and the horizontal driver circuit 309 are required to be operated at a high speed in a mode in which a frame rate is increased so that a large number of images are captured per second and thus, in many cases, are formed of a low-voltage MOS transistor. In such a case, it is useful to select the type of a gate insulating film to be used in the above-described manner.

Furthermore, with the aim of completely eliminating the problem of boron seepage, a design also has been proposed that uses a gate electrode formed of polysilicon doped with a n-type impurity for each of both gate electrode structures of n-channel MOS transistor (surface channel transistor) and a p-channel MOS transistor (buried channel transistor). In the case where this design is adopted, similarly to the above-described case, with respect to low-voltage MOS transistors, a nitrided gate insulating film is used in each of the n-channel MOS transistor and the p-channel MOS transistor, while with respect to high-voltage MOS transistors, a non-nitrided gate insulating film is used in each of the n-channel MOS transistor and the p-channel MOS transistor. This is because, since the problem of boron seepage already has been solved in this case, the selection of a gate insulating film can be made from the viewpoint of preventing gate leakage.

As described in the foregoing discussion, the present invention provides a solid-state imaging device that achieves a reduction in 1/f noise and uses a miniaturized MOS transistor, and a method of manufacturing the same, and thus is useful in realizing a solid-state imaging device that has an excellent S/N ratio and provides high image quality.

According to embodiments of the invention, a solid state imaging device may include a plurality of pixel cells that are arranged in a matrix form on a semiconductor substrate; and peripheral circuits that allow a signal to be outputted from the pixel cells via a predetermined signal line. Gate insulating films of a plurality of transistors constituting the solid-state imaging device include both a nitrided gate insulating film and a non-nitrided gate insulating film.

The invention may be used in an amplifying transistor in a pixel cell and an analog circuit as a peripheral circuit.

**Claims**

1. A solid-state imaging device, comprising:

   a plurality of pixel cells that are arranged in a matrix form on a semiconductor substrate (100); and
   peripheral circuits that allow a signal to be outputted from the pixel cells via a predetermined signal line,

   wherein gate insulating films of a plurality of transistors constituting the solid-state imaging device include both a nitrided gate insulating film (105) and a non-nitrided gate insulating film (103).

2. The solid-state imaging device according to claim 1,
   wherein among the transistors, a transistor having the non-nitrided gate insulating film (103) is an amplifying transistor in each of the pixel cells.

3. The solid-state imaging device according to claim 1 or 2,
   wherein among the transistors, a plurality of transistors constituting the peripheral circuits include both a n-channel transistor and a p-channel transistor, while at least part of transistors constituting the pixel cells is a n-channel transistor, and at least part of the n-channel transistors has the non-nitrided gate insulating film (103).

4. The solid-state imaging device according to claim 3,
   wherein the n-channel transistor includes a gate electrode (106) doped with a n-type impurity, and the p-channel transistor includes a gate electrode (106) doped with a p-type impurity.

5. The solid-state imaging device according to claim 3,
   wherein both of the n-channel transistor and the p-channel transistor include a gate electrode (106) doped with a n-type impurity.

6. A method of manufacturing a solid-state imaging device, the solid-state imaging device comprising:

   a plurality of pixel cells that are arranged in a matrix form on a semiconductor substrate (100); and
   peripheral circuits that allow a signal to be outputted from the pixel cells via a predetermined signal line,
   the method comprising the process steps of:

      forming, on the semiconductor substrate (100), a gate insulating film of transistors constituting the solid-state imaging device;
      masking a portion on the gate insulating film with a mask layer;
      performing plasma nitriding with respect to a region of the gate insulating film that is not masked with the mask layer;
      peeling off the mask layer;
      annealing the semiconductor substrate; and
      forming a gate electrode (106) on the semiconductor substrate.

7. The method according to claim 6,
   wherein a region in each of the pixel cells in which an amplifying transistor is formed is masked with the mask layer.

8. The method according to claim 6 or 7,
   wherein among the transistors, a plurality of transistors constituting the peripheral circuits include both a n-channel transistor and a p-channel transistor, while at least part of transistors constituting the pixel cells is a n-channel transistor, and a region in which at least part of the n-channel transistors is formed is masked with the mask layer.

**9.** The method according to claim 8,
wherein the n-channel transistor includes a gate electrode (106) doped with a n-type impurity, and the p-channel transistor includes a gate electrode (106) doped with a p-type impurity.

**10.** The method according to claim 8,
wherein both of the n-channel transistor and the p-channel transistor include a gate electrode (106) doped with a n-type impurity.

FIG. 1

FIG. 2A

101     101     102     101

100

FIG. 2B

101     103     103     102

100

FIG. 2C

104     104

101     103     102

100

FIG. 2D

104     104

103     101     105     102

100

FIG. 2E

101     106     103     105     106     102

100

FIG. 3
PRIOR ART

FIG. 4
PRIOR ART

FIG. 5
PRIOR ART

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004311739 A

- JP 2004296603 A